# EUROPÄISCHE PATENTSCHRIFT

(11) **EP 0 704 787 B1**
(45) Veröffentlichungstag und Bekanntmachung des Hinweises auf die Patenterteilung: **12.11.1997**
(21) Anmeldenummer: 95113633.2
(22) Anmeldetag: 30.08.1995
(51) Int. Cl.: G06F 1/10, G06F 1/12

(54) **Schaltungsanordnung zur Störbefreiung einer Taktsignalimpulsfolge**
Circuit for eliminating glitches from a series of clock pulses
Circuit pour l'élimination de parasites dans un train d'impulsions d'horloge

(30) Priorität: 23.09.1994 DE 4434084
(43) Veröffentlichungstag der Anmeldung: 03.04.1996
(73) Patentinhaber: SIEMENS AKTIENGESELLSCHAFT, 80333 München (DE)
(72) Erfinder: Prey, Gerhard, Ing.grad., D-82223 Eichenau (DE); Leitol, Stefan, Dipl.-Ing., D-81375 München (DE)

(56) Entgegenhaltungen:
- EP-A- 0 309 849
- US-A- 4 988 892
- PATENT ABSTRACTS OF JAPAN vol. 15 no. 515 (P-1293) ,27.Dezember 1991 & JP-A-03 224020 (FUJITSU LTD) 3.Oktober 1991,

## Beschreibung

Die Erfindung betrifft eine Schaltungsanordnung zur Störbefreiung einer Taktsignalimpulsfolge von mit den Impulsflanken auftretenden Störungen.

In Datenverarbeitungsanlagen mit einer Vielzahl von auf der Basis eines Taktsignals arbeitenden Einheiten wird dieser Takt an einer zentralen Stelle erzeugt bzw. eingespeist und über ein Taktverteilsystem verteilt, das unter Umständen beträchtliche Leitungslängen aufweist. Bei einem derartigen Verteilnetz besteht die Gefahr von durch Kopplungen im Augenblick der Umschaltzeitpunkte der Taktsignalimpulse entstehenden Störungen, deren Amplituden die Schaltschwellen von Eingangsschaltungen der Einheiten übersteigen und damit die Gesamtfunktion der Anlage beeinträchtigen.

Soweit hiervon zwischen den Einheiten der Datenverarbeitungsanlage zu übertragende Daten betroffen sind, lassen sich solche Störungen durch Taktung der Datensignale ausblenden, z.B. indem die Informationsaufnahme der Empfänger mit der negativen Taktflanke erfolgt, so daß die mit der positiven Taktflanke entstehenden Störungen zum Übernahmezeitpunkt schon abgeklungen sind.

Für den Takt selbst und für ein von ihm abgeleitetes Pulsrahmensignal, das als Synchronisiersignal für die Einheiten der Datenverarbeitungsanlage herangezogen wird, kann diese Methode natürlich nicht angewendet werden.

Bisher wurde daher in Fällen solcher Datenverarbeitungsanlagen das Verteilnetz für Takt- und Synchronisierimpulse durch entsprechende Entkopplungsmaßnahmen störunempfindlich gemacht, bzw. durch Verwendung von störunempfindlichen Empfangsgattern die Auswirkung von Störungen vermieden.

Eine solche Lösung erfordert allerdings einen beträchtlichen Aufwand, gegebenenfalls werden auch die Laufzeiten und Laufzeittoleranzen auf dem Verteilsystem zu hoch.

Die Aufgabe der Erfindung besteht daher darin, eine Schaltungsanordnung anzugeben, mit der in der genannten Art gestörte Taktimpulsfolgen von Störungen befreit werden, um mit vergleichsweise geringem Aufwand einen ordnungsgemäßen Datenverarbeitungsbetrieb gewährleisten zu können.

Eine Schaltungsanordnung gemäß der Lösung dieser Aufgabe weist die im Kennzeichen des Patentanspruchs 1 angegebenen Merkmale auf.

Durch die erfindungsgemäße Schaltungsanordnung ist also bewirkt, daß ein nach einer Impulspause auftretender Flankenwechsel, unabhängig davon, ob er als Störung zu betrachten ist, weil damit der volle Signalwert nicht erreicht wird, oder ob er eine ungestörte Impulsflanke darstellt, ausgangsseitig zu einem Potentialsprung führt, der einen ungestörten Impuls darstellt. Danach innerhalb der vordefinierten Zeitspanne auftretende Potentialwechsel bleiben ohne Auswirkung. Auf einen Flankenwechsel am Impulsende folgende weitere Flankenwechsel wirken sich ebenfalls nicht aus, sofern sie innerhalb der vordefinierten Zeit liegen.

Eine spezielle Ausgestaltung der erfindungsgemäßen Schaltungsanordnung ist in einem Unteranspruch gekennzeichnet.

Eine Schaltungsanordnung zur Störbefreiung des erwähnten Pulsrahmen- bzw. Synchronisiersignals ist Gegenstand einer anderen Patentanmeldung.

Nachstehend wird die Erfindung anhand eines Ausführungsbeispiels unter Bezugnahme auf eine Zeichnung näher erläutert.

In der Zeichnung zeigen:

Figur 1 als Beispiel für das Verteilsystem für Takt- und Synchronisierimpulse den Teil einer Datenverarbeitungsanlage in Form einer Fernsprechvermittlungsanlage, der ein solches Verteilsystem beinhaltet.

Figur 2 ein Ausführungsbeispiel der erfindungsgemäßen Schaltungsanordnung.

Figur 3 ein den Betrieb dieser Schaltungsanordnung veranschaulichendes Impulsdiagramm.

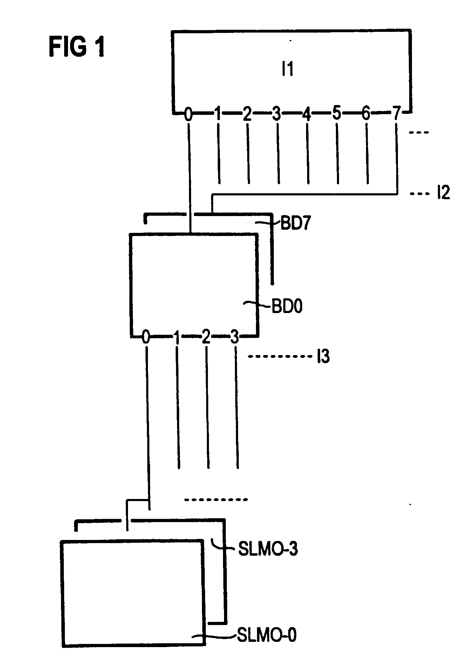

In der Figur 1 ist ein Teil einer Fernsprechvermittlungsstelle angedeutet, der deren Peripherie angehört. Es sind vier Anschlußbaugruppen SLMO-0 bis SLMO-3 gezeigt, an die Teilnehmeranschlußleitungen angeschlossen zu denken sind. Diese Anschlußbaugruppen enthalten eine entsprechende Anzahl von Teilnehmersätzen, sowie einen Anschlußgruppenprozessor.

Die genannten Anschlußbaugruppen sind Teil einer größeren Mehrzahl, die beispielsweise 128 betragen kann.

Die Figur 1 zeigt ferner eine zentrale Schnittstelleneinheit I1, über die der Datenaustausch mit den zentralen Teilen der Vermittlungsstelle erfolgt und über die die Anschlußbaugruppen mit Taktimpulsen und Synchronisiersignalen versorgt werden. Verteilereinheiten BD0 bis BD7 sorgen für eine teilzentrale Verteilung von Daten-, Takt- und Synchronisiersignalen. Sie bilden eingangsseitig eine Schnittstelle I2 und ausgangsseitig eine Schnittstelle I3. Der Ausgang 0 des zur Verteilereinheit BD0 gehörigen Teils der Schnittstelle I3 führt, wie dargestellt, zu den gezeigten Anschlußbaugruppen SLMO-0 bis SLMO-3. Die übrigen Ausgänge dieser Verteilereinheit bzw. die Ausgänge der übrigen Verteilereinheiten führen zu hier nicht dargestellten weiteren Anschlußbaugruppen.

Die Verbindungen des dargestellen Verteilernetzes mögen der Verteilung der Taktimpulssignale dienen. Entsprechende Verbindungen sind für die Übertragung des Pulsrahmensignals und der Daten zu denken.

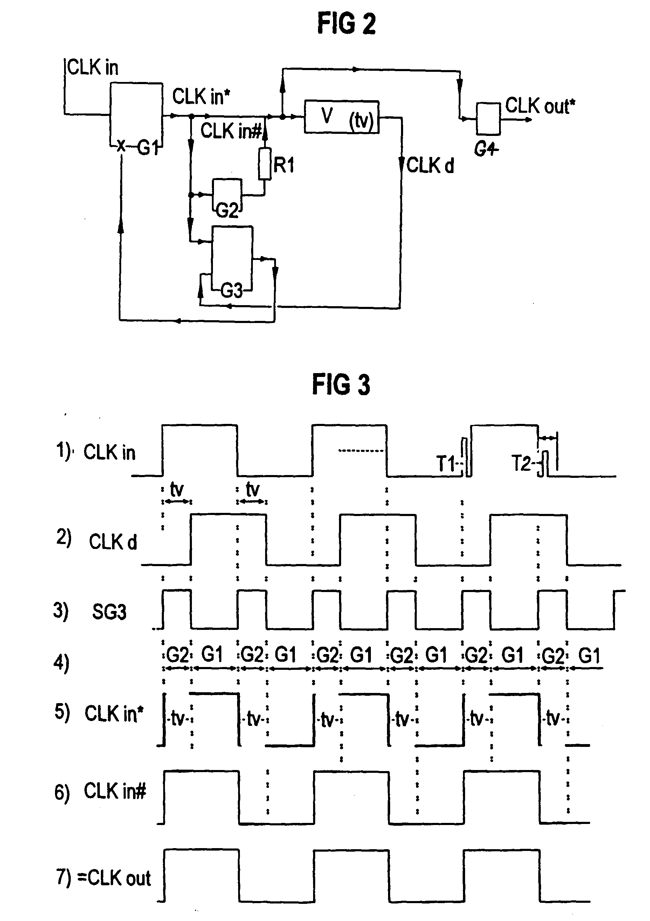

Die in Figur 2 dargestellte Schaltung ist bei einem Einsatz in einer Anordnung gemäß Figur 1 jeweils den Ausgängen der Verteileinheiten BD0 bis BD7 zugeordnet, an die sie störbefreite Taktimpulse liefert, von wo aus bis zu den Anschlußbaugruppen SLMO-0 bis SLMO-3 nur noch Leitungsverbindungen von höchstens 60 cm zu durchlaufen sind, so daß hier störende Kopplungen ohne besonderen Aufwand vermieden werden können. Sollten die bei den Anschlußbaugruppen ankommenden Taktsignale dennoch störbehaftet sein, so kann die erfindungsgemäße Schaltungsanordnung auch deren Eingängen zugeordnet sein.

Eingangsseitig weist die Schaltungsanordnung gemäß Figur 2 ein Sperrgatter G1 auf, dem die unter Umständen störbehafteten Taktimpulse zugeführt werden.

An den Ausgang dieses Sperrgatters G1 ist eine Treiberschaltung G2 angeschlossen, deren Ausgang über einen Widerstand R1 an den Eingang rückgekoppelt ist.

Der Ausgang des Sperrgatters G1 steht ferner mit dem Eingang eines Verzögerungsgliedes V in Verbindung, dessen Ausgang mit dem einen Eingang eines Vergleichers G3 verbunden ist, dessen anderer Eingang ebenfalls mit dem Ausgang des Sperrgatters G1 in Verbindung steht. Das Ausgangssignal des Vergleichers G3 wird dem Sperreingang X des Sperrgatters G1 zugeführt.

Die insoweit beschriebene Schaltungsanordnung gemäß Figur 2 bildet, wie nachstehend noch erläutert werden wird, eine Halteschaltung, die so geartet ist, daß sie einen Potentialwechsel am Impulsanfang und am Impulsende unverzögert an den Ausgang der Schaltungsanordnung in Form eines Potentialsprungs in Höhe der Impulsamplitude weitergibt und zwar unabhängig davon, ob der eingangsseitige Potentialwechsel zum Erreichen der Impulsamplitude führt oder nicht, wenn nur ein Schwellwert überschritten wird. Danach an ihrem Eingang auftretende Potentialwechsel gibt sie bis zum Ablauf einer bestimmten Zeitspanne nicht weiter. Die Zeitspanne ist so bemessen, daß nach ihrem Ablauf am Impulsanfang und am Impulsende auftretende Störungen abgeklungen sind. Die Haltefunktion könnte auch mit Hilfe einer bistabilen Kippstufe erzeugt werden.

In Figur 3 zeigt Zeile 1) eine Taktimpulsfolge CLKin, wie sie dem Sperrgatter G1 zugeführt wird. Im linken Teil dieser Zeile sind die Impulse ohne Störungen dargestellt, im rechten Teil ist beispielhaft gezeigt, daß die Vorderflanke eines Impulses in der Weise störbehaftet ist, daß bei dem auf die Impulspause folgenden Flankenwechsel das Signal noch nicht die volle Amplitude erreicht, und wieder auf den Wert vor der Flanke zurückfällt, siehe T1, also gestört ist und erst nach einer Störzeit den korrekten Wert annimmt. Die Abfallflanke ist in der Weise gestört, daß auf sie noch ein kurzer ebenfalls nicht den vollen Signalwert erreichender Impuls, siehe T2, folgt.

Da nach einer Impulspause, die wesentlich länger als die Verzögerungszeit tv des Verzögerungsgliedes V dauert, an beiden Eingängen des Vergleichers G3 dasselbe der Impulspause entsprechende Potential anliegt, vergleiche Zeile 5), die den Potentialverlauf CLKin* am Ausgang des Sperrgliedes G1 zeigt, mit Zeile 2), in der das Ausgangssignal CLKd des Verzögerungsgliedes dargestellt ist, der Vergleicher also ein das Sperrgatter durchlässig schaltendes Signal liefert, siehe SG3 in Zeile 3, kann ein nachfolgender Flankenwechsel am Eingang des Sperrgatters auf dessen Ausgang durchgreifen. Unabhängig davon, ob dieser Flankenwechsel störbedingt die Impulsamplitude nicht erreicht oder zum der Impulsamplitude entsprechenden Potentialwert führt, erreicht das Ausgangssignal CLKout, siehe Zeile 7) in Figur 3, den vollen Signalwert.

Dieser Potentialsprung steht sofort am einen Eingang des Vergleichers G3 und auch am Eingang des Verzögerungsgliedes V an, das jedoch nach wie vor als Ausgangssignal das der Impulspause entsprechende Potential an den anderen Vergleichereingang liefert, weswegen der Vergleicher nunmehr Ungleichheit signalisiert, siehe Zeile 3), und dementsprechend das Sperrgatter undurchlässig macht, beispielsweise in einen passiven Tristate-Zustand schaltet. Wie die Zeile 5) zeigt, bestimmt der Ausgang des Sperrgatters G1 nach diesem Potentialsprung den weiteren Signalverlauf zunächst nicht mehr.

Da der genannte Potentialsprung aber auch an den Eingang der rückgekoppelten Treiberschaltung G2 gelangt ist, wird das erreichte Potential aufrechterhalten, was die Zeile 6) zeigt, in der ein Potentialverlauf CLKin# gezeigt ist, wie er am Ausgangsanschluß des Widerstands R1 auftritt und der mit dem über die Treiberschaltung G4 an den Ausgang der Gesamtschaltungsanordnung weitergegebenen Signalverlauf CLKout übereinstimmt, siehe Zeile 7). In der Zeile 4) ist der Wechsel der Verantwortlichkeit der Ausgänge des Sperrgliedes G1 und des Ausganges des Widerstandes R1 für den Verlauf des von der Schaltunggsanordnung abgegebenen Signals nochmals veranschaulicht. Potentialänderungen, die innerhalb der Verzögerungszeit tv des Verzögerungsgliedes V bzw. während der Zeit auftreten, während der das Sperrgatter G1 sich im Tristate-Zustand befindet, können also ausgangsseitig die Potentialverhältnisse nicht beeinflussen.

Nach Ablauf der Verzögerungszeit signalisiert der Vergleicher G3 wieder Gleichheit, so daß das Sperrgatter wieder in den aktiven Zustand geschaltet wird und damit wieder auf einen Flankenwechsel reagieren kann. Wegen der die Zeitspanne, während der Störungen auftreten können, überdauernden Verzögerungszeit wird es sich dabei um die nachfolgende Abfallflanke des Impulses handeln.

Damit es in der dementsprechenden Übergangsphase nicht zu einer Kollision mit dem durch den Treiber G2 über den Widerstand R1 gelieferten Ausgangssignal kommt, ist der Widerstand R1 so bemessen, daß sich das vom nunmehr aktiven Sperrgatter gelieferte Potential CLKin* gegen das am Ausgang des Widerstands R1 auftretende Potential CLKin# durchsetzen kann.

Mit diesem letztgenannten Flankenwechsel liegen aber wieder sofort unterschiedliche Potentiale an den Eingängen des Vergleichers G3, womit das Sperrgatter erneut in den passiven Zustand geschaltet wird, mit der Folge, daß Störungen der Rückflanke eines Taktimpulses, siehe T2 in Zeile 1), nicht durchgreifen können. Das dem Vorliegen der Impulspause entsprechende Potential wird von da an bis zum Ablauf der Verzögerungszeit wieder vom rückgekoppelten Treiber G2 bestimmt, erst danach überwiegt wieder die Wirkung des erneut aktiv geschalteten Sperrgatters G1, siehe im Vergleich die Zeilen 4) und 5) der Figur 3.

## Patentansprüche

1. Schaltungsanordnung zur Störbefreiung einer Taktsignalimpulsfolge mit vorgegebener Impulsamplitude, wobei die Störungen an den Impulsflanken auftreten,
**dadurch gekennzeichnet**, daß
sie eine Halteschaltung umfaßt, der die Taktimpulsfolge zugeführt wird und die einen am Impulsanfang und am Impulsende auftretenden Potentialsprung, sofern er einen Schwellwert überschreitet, unabhängig von seiner Höhe als Potentialsprung in der Höhe der Impulsamplitude an den Schaltungsausgang weitergibt, sowie den dann erreichten Potentialwert unabhängig vom weiteren Potentialverlauf an ihrem Eingang für eine vordefinierte Zeitspanne aufrechterhält, nach der eine am Impulsanfang und am Impulsende auftretende Störung abgeklungen ist.

2. Schaltungsanordnung nach Anspruch 1,
**dadurch gekennzeichnet**, daß
die Halteschaltung aus folgenden Bestandteilen besteht:
a) einem digitalen Sperrgatter (G1), dem die Taktimpulsfolge (CLKin) zugeführt wird,
b) einer mit seinem Eingang direkt und mit seinem Ausgang über einen Widerstand (R1) an den Ausgang des Sperrgatters angeschlossenen Treiberschaltung (G2),
c) einem an den Ausgang des Sperrgatters angeschlossenen Verzögerungsglied (V) mit der genannten Haltezeitspanne entsprechender Verzögerungszeit
d) einem Vergleicher (G3), der eingangsseitig einerseits an den Ausgang des Sperrgatters und andererseits an den Ausgang des Verzögerungsgliedes angeschlossen ist und dessen Ausgang mit dem Sperreingang (x) des Sperrgatters verbunden ist, und daß eine Ausgangstreiberschaltung (G4) vorgesehen ist, die das am Ausgang des Sperrgatters jeweils vorliegende Potential als störbereinigtes Taktimpulssignal (CLKout) weitergibt.

## Claims

1. Circuit arrangement for eliminating glitches from a clock-signal pulse train having a predetermined pulse amplitude, the glitches occurring on the pulse edges, characterized in that it comprises a holding circuit to which the clock pulse train is fed and which forwards a sudden potential change which occurs at the start of a pulse and at the end of a pulse, provided that the said sudden potential change exceeds a threshold value, irrespective of its level as a sudden potential change at the level of the pulse amplitude to the circuit output, and maintains the potential value which is then reached, irrespective of the further potential profile at its input, for a predefined time interval after which a glitch which occurs at the start of a pulse and at the end of a pulse has decayed.

2. A circuit arrangement according to Claim 1, characterized in that the holding circuit comprises the following component parts:
a) a digital inhibit gate (G1), to which the clock pulse train (CLKin) is fed,
b) a driver circuit (G2), the input of which is connected directly to the output of the inhibit gate and the output of which is connected via a resistor (R1) to the output of the inhibit gate,
c) a delay element (V), which is connected to the output of the inhibit gate and has a delay time which corresponds to the said holding time interval
d) a comparator (G3), which, on the input side, is connected to the output of the inhibit gate, on the one hand, and to the output of the delay element, on the other hand, and whose output is connected to the inhibit input (x) of the inhibit gate,
and in that an output driver circuit (G4) is provided which forwards the potential respectively present at the output of the inhibit gate as clock pulse signal (CLKout) from which glitches have been removed.

## Revendications

1. Montage pour l'élimination des parasites dans un train d'impulsions d'horloge dont l'amplitude est prédéfinie, les parasites apparaissant aux flancs des impulsions,
**caractérisé par**
le fait que ce montage comporte un circuit de retenue auquel est appliqué le train d'impulsions d'horloge, qui transmet, à la sortie du montage et avec l'amplitude des impulsions, le saut de potentiel apparaissant au début et à la fin des impulsions, indépendamment de l'amplitude de ce demier dans la mesure où il dépasse une valeur seuil, et qui maintient, pour une période de temps prédéfinie et après laquelle un parasite apparaissant au début et à la fin de l'impulsion est amorti, la valeur du potentiel ainsi atteinte, indépendamment de l'évolution ultérieure du potentiel à son entrée.

2. Montage conforme à la revendication 1,
**caractérisé par**
le fait que le circuit de retenue se compose des éléments suivants:
a) une porte de blocage numérique (G1), sur laquelle le train d'impulsions d'horloge (CLKin) est appliqué,
b) un circuit d'excitation ou générateur (G2) raccordé à la sortie de la porte de blocage directement par son entrée et à travers une résistance (R1) par sa sortie,
c) un élément de temporisation (V) raccordé à la sortie de la porte de blocage et ayant un facteur de temporisation correspondant à la période de retenue citée,
d) un comparateur (G3), qui est raccordé, côté entrée, d'une part à la sortie de la porte de blocage et, d'autre part, à la sortie de l'élément de temporisation et dont la sortie est reliée à l'entrée de blocage (x) de la porte de blocage
et le fait que, à la sortie, est prévu un circuit d'excitation ou générateur (G4) qui transmet, en tant que signal d'impulsions d'horloge dénué de parasites (CLKout), le potentiel présent à la sortie de la porte de blocage.
